# FASCICULE DE BREVET EUROPEEN

(11) **EP 2 226 839 B1**
(45) Date de publication et mention de la délivrance du brevet: **06.01.2016**
(21) Numéro de dépôt: 10154789.1
(22) Date de dépôt: 26.02.2010
(51) Int. Cl.: H01L 21/768

(54) **Procédé de réalisation de lignes d'interconnexion métallique**
Verfahren zur Herstellung von Leitungen mit Metallverbindungen
Method for manufacturing metal interconnection lines

(30) Priorité: 06.03.2009 FR 0951436
(43) Date de publication de la demande: 08.09.2010
(73) Titulaire: Commissariat à l'Énergie Atomique et aux Énergies Alternatives, 75015 Paris (FR)
(72) Inventeur: Carreau, Vincent, 94120, FONTENAY SOUS BOIS (FR)
(74) Mandataire: Esselin, Sophie

(56) Documents cités:
- US-A1- 2005 003 654
- US-A1- 2008 211 098
- US-B1- 6 500 749
- SPOLENAK ET AL: "Reversible orientation-biased grain growth in thin metal films induced by a focused ion beam", SCRIPTA MATERIALIA, vol. 53, no. 11, 1 décembre 2005 (2005-12-01), pages 1291-1296, XP005077077, ELSEVIER, AMSTERDAM, NL ISSN: 1359-6462
- CARREAU ET AL: "Evolution of Cu microstructure and resistivity during thermal treatment of damascene line: Influence of line width and temperature", MICROELECTRONIC ENGINEERING, vol. 84, no. 11, 25 septembre 2007 (2007-09-25), pages 2723-2728, XP022266667, ELSEVIER PUBLISHERS BV., AMSTERDAM, NL ISSN: 0167-9317
- CARREAU V ET AL: "Cu grain growth in interconnects trenches - Experimental characterization of the overburden effect", MICROELECTRONIC ENGINEERING, vol. 85, no. 10, octobre 2008 (2008-10), pages 2133-2136, XP002549057, ELSEVIER ,NL

## Description

Le domaine de l'invention est celui des interconnexions métalliques utilisées dans les circuits intégrés.

De manière générale, le choix du matériau métallique est lié à la résistivité du métal qui est une des caractéristiques clé dans le choix des interconnexions électriques. En effet, la résistivité joue sur au moins trois paramètres qui sont le temps de propagation des signaux, la chute de tension et les échauffements par effet Joule. Une faible résistivité des conducteurs est donc un paramètre essentiel pour le choix des matériaux utilisés.

Le cuivre est un des métaux massifs avec l'argent présentant une des résistivités électriques les plus faibles. C'est une des raisons avec la résistance au phénomène d'électromigration pour lesquelles il est actuellement utilisé en très haute densité d'intégration.

Néanmoins, les interconnexions en cuivre se heurtent à deux types de problèmes qui sont que le cuivre est difficile à graver et qu'il présente un haut pouvoir de diffusion dans de nombreux matériaux. Cette diffusion peut conduire à la mise en court-circuit de pistes voisines, et donc à un dysfonctionnement global d'un circuit.

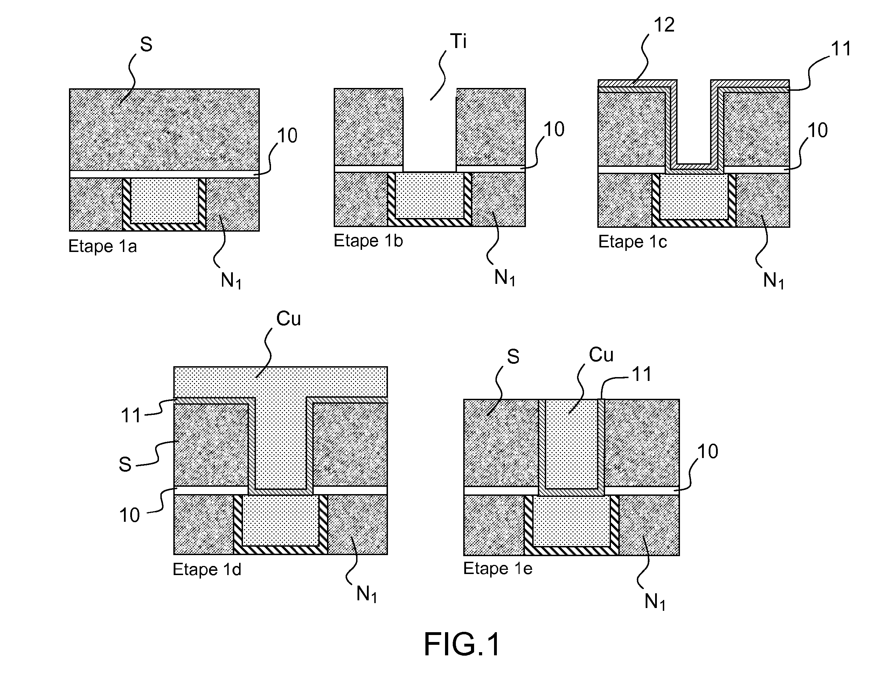

Le procédé Damascène décrit ci-après et illustré en figure 1 a été développé pour permettre de surmonter ces deux inconvénients.

Il repose notamment sur une succession d'étapes qui sont les suivantes : dépôt d'une couche de diélectrique isolante inter-niveaux, gravure des motifs (dénommé « patterns » en anglais) d'interconnexion, constitués par des lignes et des via dans la couche diélectrique, notamment par gravure ionique réactive (couramment dénommée en anglais « R.I.E » pour reactive ion etching), dépôt d'une couche barrière dans le diélectrique, servant à empêcher la migration du cuivre, remplissage des lignes et vias par le cuivre, élimination du cuivre en excès par polissage mécano-chimique.

Le dépôt de cuivre est réalisé par électrodéposition, procédé qui offre de bonnes performances en terme de qualité de dépôt, en permettant un remplissage effectif des tranchées. Ce procédé peut être par exemple basé sur le dépôt galvanique de cuivre à partir d'un bain contenant notamment du sulfate de cuivre (CuSO₄) et des additifs.

Les différentes étapes de ce procédé sont illustrées sur la figure 1.

Plus précisément, après le dépôt d'un diélectrique d'encapsulation 10, sur un premier niveau d'interconnexions N₁, correspondant à l'étape 1a, on réalise des tranchées Ti par gravure dans des endroits destinés à la réalisation des interconnexions (étape 1b) au sein d'un substrat S en diélectrique ; une barrière de diffusion 11 puis une couche conductrice 12 sont déposées à la surface des tranchées (étape 1c) afin de permettre le remplissage des tranchées par du cuivre Cu par électrochimie (étape 1d). Après une étape de recuit, le cuivre en excès en surface est retiré lors d'une opération de polissage mécano-chimique (étape 1e), cette dernière opération est couramment dénommée procédé « CMP ».

Le procédé CMP est un procédé de lissage et de planarisation des surfaces combinant des actions chimiques et mécaniques, utilisant un mélange de gravure chimique et de polissage mécanique à abrasif libre. Le rodage mécanique seul cause trop de dégâts sur les surfaces et la gravure humide seule ne permet pas d'obtenir une bonne planarisation. Les réactions chimiques étant isotropiques, elles attaquent les matériaux indifféremment dans toutes les directions. Le CMP combine les deux effets en même temps.

Cependant dans les milieux de petites dimensions, inférieures typiquement à quelques centaines de nanomètres (environ 200 nm), les propriétés du cuivre évoluent. C'est ainsi que la résistivité du cuivre augmente lorsque la largeur de ligne diminue comme décrit dans l'article de W. Steinhoegl, G.Schindler and M.Engelhardt, Unraveling the mysteries behind siez effects in metallization systems, Semiconductor international, Janvier 2005.

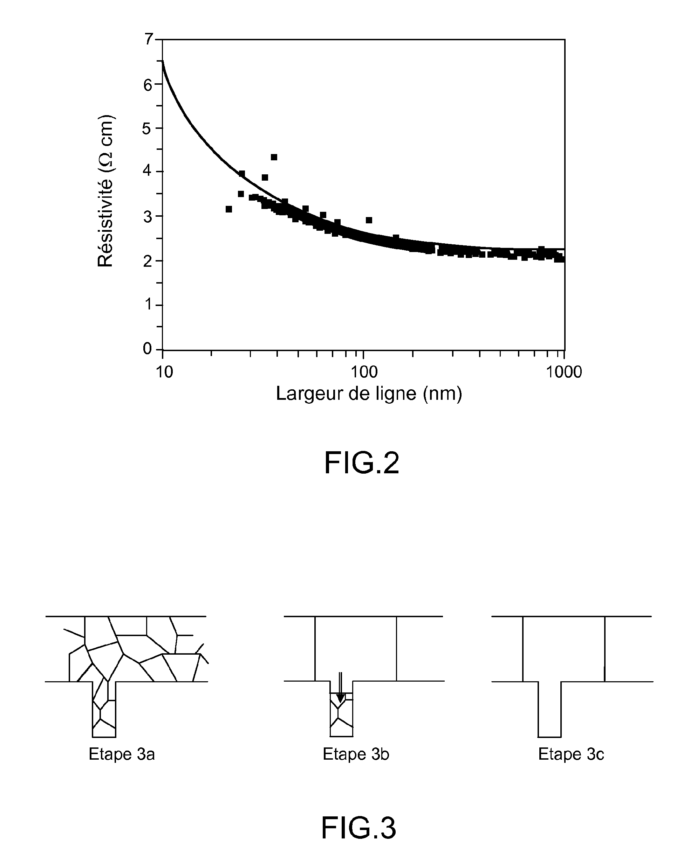

La figure 2 illustre à ce titre, l'évolution de la résistivité de lignes de cuivre en fonction de la largeur de lignes correspondant à la largeur des tranchées, obtenues selon le procédé Damascène.

Plusieurs facteurs sont à prendre en compte. Tout d'abord, pour éviter la formation de cavités dans les lignes, l'usage d'additifs durant la croissance électrochimique du cuivre est nécessaire. Ces additifs peuvent être incorporés dans le cuivre sous forme d'impuretés lors du dépôt et ainsi modifier ses propriétés. Toutefois, les principaux facteurs de cette évolution de la résistivité sont liés à la géométrie des lignes, notamment ses dimensions. Il apparait que la taille de grain d'un matériau est limitée par le confinement, la dimension la plus petite du milieu. Ce phénomène est notamment décrit dans l'article de Q-T.Jiang, M.Nowell ; B.Foran, A.Frank, R.H.Haveman, V.Parihan, R.A.Augur and J.D.Luttmer, Analysis of copper grains in damascence trenches after rapid thermal processing or furnace anneals, Journal of electronic material.31(1) : 10-15, Janvier 2002.

Ainsi dans les lignes étroites, la taille de grain devient de l'ordre de grandeur du libre parcours moyen des électrons dans le cuivre massif (soit 38 nm à 300 K). Les électrons ont alors tendance à diffuser sur les joints de grain, par du passage de courant.

De plus, pour les petites tailles de lignes (typiquement inférieures à 100 nm de large), une faible taille de grain est une cause aggravant les phénomènes liés à l'électro-migration qui réduisent la durée de vie des interconnexions, les joints de grain étant des chemins de diffusions atomiques possibles, comme décrit dans l'article Changsunp Ryu, Kee-Won Kwon, Alvib L.S.Loke, Haebum Lee, Takeshi Nogami, Valery M.Dubin, Rahim A.Kavari, Gary W.Ray,and S.Simon Wong, IEEE TRANSACTIONS ON ELECTRON DEVICES, 46 (6) (1999), 1113-1120.

La microstructure du cuivre est liée au procédé technologique utilisé pour son intégration, et typiquement selon le procédé Damascène, la taille de grain après le dépôt électrochimique est petite. Un recuit de croissance de grain est pratiqué et lors de ce recuit, le surplus de cuivre est encore présent.

Le mécanisme de croissance des grains s'effectue selon le schéma illustré en figure 3. L'étape 3a est relative à la phase juste postérieure au dépôt électrochimique dans laquelle les grains sont petits.

En plus d'une croissance des grains dans la ligne, on observe une invasion des grains de la surépaisseur dans la tranchée comme illustré en étape 3b, ce mécanisme peut se prolonger jusqu'à une invasion totale de la tranchée comme illustré en étape 3c.

Il a été montré que l'étendue de ce mécanisme dépend de la température de recuit et des dimensions : « Cu grain growth in interconnects trenches - Experimental characterization of the overburden effect » Carreau V., Maitrejean S., Brechet Y., Verdier M., Boucu D., Passemard G., Microelectronic Engineering, Volume 85, Issue 10, October 2008, Pages 2133-2136

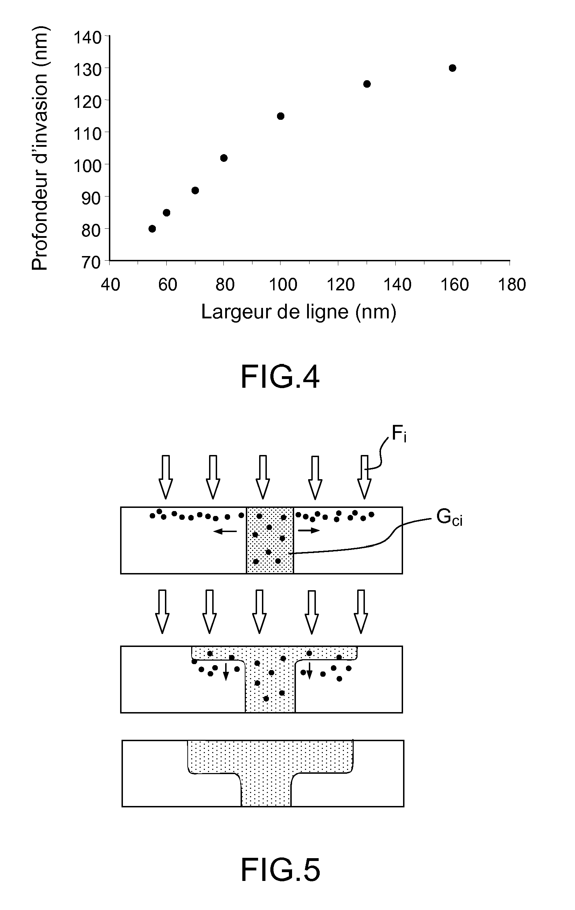

Ainsi, pour des recuits à 150 degrés, une profondeur limite d'invasion a été déterminée en fonction de la largeur de la ligne comme le montre la courbe de la figure 4 qui illustre la profondeur d'invasion en fonction de la largeur de tranchée pour des lignes de cuivre recuites à 150°C et ce pendant 6 heures. Cette profondeur limite décroit lorsque la largeur de ligne diminue.

Toutefois, il a également été montré que ce mécanisme de croissance permet d'obtenir une taille de grain plus importante dans les lignes.

Une solution alternative au recuit thermique pour l'obtention de gros grains est l'implantation ionique. Cette méthode utilise la densité de défauts cristallins comme force motrice au mouvement de joints de grains.

Les grains de cuivre qui ont une densité de défauts plus importante sont consommés au détriment des grains qui en ont moins. A volume constant, le nombre de grains diminue, leur taille moyenne augmente donc.

Sous l'incidence d'un faisceau ionique, des défauts cristallins apparaissent dans un matériau en fonction de l'orientation cristalline de celui-ci. Deux populations de grains sont alors à distinguer : les grains qui sont orientés de façon à canaliser les ions incidents et les autres comme décrit dans l'article de R. Spolenak, L. Sauter, C.Eberl, Revesible orientation-biased garin growth in thin metal films induced by a focused ion beam, Scripta materiala, 53, 1291-1296, 2005.

Les grains qui canalisent les ions croissent au dépend des grains qui ne canalisent pas les ions incidents comme illustré en figure 5. Sous l'action d'un flux d'implantation ionique Fi, les grains qui canalisent les ions référencés Gci peuvent croître au dépend des grains qui ne canalisent pas les ions, situés en périphérie du grain Gci.

La faisabilité de cette technique a été démontrée par l'implantation ionique d'ions Ga⁺ (R. Spolenak, L. Sauter, C.Eberl, Revesible orientation-biased garin growth in thin metal films induced by a focused ion beam, Scripta materiala, 53, 1291-1296, 2005) et d'ions Ar⁺ (S.Olliges, P. Gruber, A.Bardill, D.Ehrler, H.D.Cartanjen, R.Spolenak, Converting polycrystals into single crystal-Selective garin growth by high-energy ion bombardment, Acta Materiala, 54, 5393-5300, 2006) dans des films minces. Les effets de l'implantation ionique sur la taille de grains sont décelables jusqu'à des profondeurs d'environ 500 nm.

De manière générale, la croissance de la couche de cuivre est polycristalline. On définit la notion de joints de grains par l'interface entre deux domaines cristallins dans une structure polycristalline.

La taille des grains dépend de la surface du substrat, des conditions de croissance aussi bien que des dimensions des tranchées.

Des résultats de mesure d'orientations cristallines dans des structures de type Damascène montrent que les grains issus de l'invasion de la surépaisseur ont une orientation différente de ceux issus de la croissance dans la ligne de connexion comme cela est décrit dans l'article de B. Kaouache, S. Labat, O. Thomas, S. Maitrejean, V. Carreau : « Texture and strain in narrow copper damascene interconnect lines: An X-ray diffraction analysis » Microelectronic Engineering, Volume 85, Issue 10, October 2008, Pages 2175-2178*.*

Les grains issus de la croissance dans la ligne sont orientés avec une direction <111> perpendiculaire au substrat et une direction <110> dans le sens de la ligne.

Les grains issus de l'invasion montrent une direction <001> perpendiculaire au substrat.

US2005/0003654 A1 divulgue un procédé de réalisation de lignes d'interconnexion en cuivre comprenant les étapes de la réalisation d'une couche d'invasion de cuivre au dessus des tranchées remplies par des grains de cuivre et une implantation ionique de la couche d'invasion par un faisceau d'ions.

La présente invention a pour objet un procédé permettant d'optimiser la résistance à l'électro-migration en diminuant le nombre de joints de grain dans la section de la tranchée et ce en optimisant la direction cristalline à favoriser au niveau de la surépaisseur métallique au dessus de la tranchée.

Plus précisément l'invention a pour objet un procédé de réalisation de lignes d'interconnexion métallique à la surface d'un substrat avec les étapes décrites dans la revendication 1.

Selon une variante de l'invention, l'épaisseur de la couche d'invasion présente une épaisseur initiale au moins égale à la hauteur d'une tranchée.

Selon une variante de l'invention, la détermination de la première et de la seconde directions d'orientation des grains dans une tranchée comporte en outre :
- après le dépôt électrochimique, le retrait d'une couche de surépaisseur de manière à dégager le dépôt de métal à l'intérieur d'une tranchée;
- une opération de recuit à une température permettant de stabiliser la microstructure obtenue à partir du dépôt de métal à l'intérieur d'une tranchée;
- une analyse par diffraction X permettant d'identifier ladite première direction d'orientation des grains dans la tranchée.

Selon une variante de l'invention, le métal étant du cuivre, et les lignes ayant une largeur inférieure à environ 200 nm, la première direction est définie par l'ensemble cristallographique <110>, la seconde direction est définie par l'ensemble cristallographique <111>, la direction de canalisation est définie par l'ensemble cristallographique <110> au sein de la maille cubique face centrée du cuivre, les directions d'orientation d'un faisceau d'implantation ionique font un angle de l'ordre de 35° avec la direction <111>.

Selon une variante de l'invention, le métal étant du cuivre, l'implantation ionique est effectuée avec des ions de type Ga⁺.

Selon une variante de l'invention, l'implantation ionique est effectuée par un faisceau de puissance ionique généré avec une tension d'accélération inférieure ou égale à environ 300 kV.

Selon une variante de l'invention, le procédé comporte en outre une étape de recuit postérieure à l'étape d'implantation ionique.

Selon une variante de l'invention, le procédé comporte en outre une étape d'un premier polissage permettant d'optimiser l'épaisseur de la couche dite d'invasion par réduction d'épaisseur, préalable à l'opération d'implantation ionique, en fonction de la largeur de ligne.

Selon une variante de l'invention, le procédé comporte en outre la réalisation d'un dépôt de couche métallique à la surface desdites tranchées de manière à éviter toute diffusion de métal au sein desdites tranchées.

Avantageusement, la couche métallique est en métal de type tantale ou nitrure de tantale.

L'invention sera mieux comprise et d'autres avantages apparaîtront à la lecture de la description qui va suivre donnée à titre non limitatif et grâce aux figures annexées parmi lesquelles :
- la figure 1 illustre les différentes étapes d'un procédé de type Damascène selon l'art connu permettant la réalisation de lignes d'interconnexions en cuivre ;
- la figure 2 illustre l'évolution de la résistivité de lignes d'interconnexion obtenue par un procédé de type Damascène en fonction de leur largeur ;
- la figure 3 illustre les mécanismes de croissance de grain dans une structure intégrant une ligne et un surplus de cuivre dans un procédé comportant une étape d'implantation ionique selon l'art connu ;
- la figure 4 illustre la profondeur d'invasion en fonction de la largeur de tranchée pour des lignes de cuivre recuites à 150 °C pendant 6 heures dans un procédé de l'art connu ;
- la figure 5 illustre le processus de propagation d'un grain canalisant les ions d'un film mince;
- la figure 6 illustre le résultat d"une simulation SRIM de défauts crées par l'implantation d'ions Cu dans du cuivre à une énergie de 70kV ;
- les figures 7a et 7b illustrent respectivement une vue d'une maille cubique à face centrée de cuivre et une représentation schématique d'une ligne de cuivre avec une direction privilégiée d'orientation de faisceau d'implantation ionique.

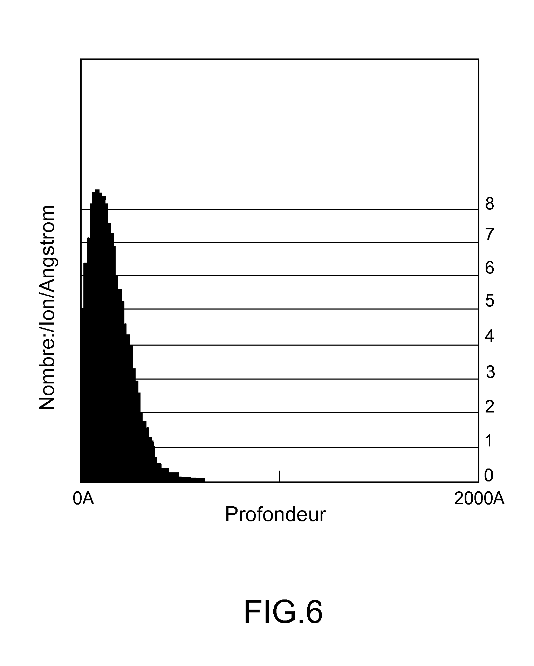

Selon l'invention, il est ainsi proposé de pratiquer une croissance de grain assistée par implantation ionique dans le surplus de métal à la surface du substrat qui sert également de protection au diélectrique dit interligne face aux espèces implantées. Les espèces implantées sont limitées en profondeur dans un matériau donné selon leur nature comme le montre l'exemple d'ions cuivre dans du cuivre sur la figure 6.

Cette figure illustre le nombre de défauts créés par l'implantation d'ions de cuivre dans du cuivre à une énergie de 70 KV, en fonction de la profondeur de pénétration. Ces résultats sont issus d'un programme pour le calcul et la simulation de la perte d'énergie des noyaux dans divers matériaux, développé par J.F. Ziegler (J. P. Biersack and L. Haggmark, Nucl. Instr. and Meth., vol. 174, 257, 1980, J. F. Ziegler : "The Stopping and Range of Ions in Malter", volumes 2 - 6, Pergamon Press, 1977-1985), programme "SRIM".

Une amélioration significative du phénomène d'invasion est ainsi rendue possible en orientant les grains de la surépaisseur selon l'orientation naturelle des grains dans les lignes et le phénomène de friction limitant l'invasion en est également diminué.

L'invention est décrite ci-après dans le cadre de lignes d'interconnexion réalisées en cuivre mais pourrait tout aussi bien être appliquée dans le cadre d'un autre métal de type aluminium ou argent.

Le cuivre cristallise dans une maille cubique face centrée et présente une direction privilégiée de canalisation d'ions D₃ correspondant à la direction <110>.

Par ailleurs comme décrit précédemment, la direction privilégiée d'orientation D₁ des grains le long de la ligne est également définie par la direction <110>.

Les directions d'implantation ionique sont ainsi définies par le produit scalaire de D₁ ou D₃ avec D₂, soit le produit scalaire de <110> par <111>.

Selon l'invention il est proposé de déterminer l'angle avec lequel il convient de désorienter un substrat de silicium de façon à mettre en concordance une direction <110> favorable précédemment déterminée et la direction du faisceau d'ions incident.

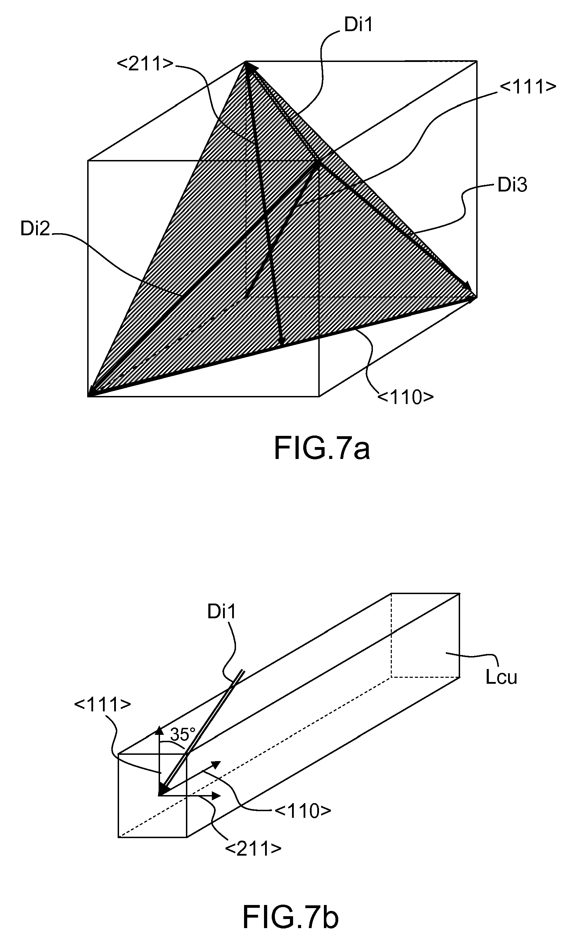

Pour ce faire, on détermine un ensemble de directions <110> favorable dont on détermine l'angle par rapport à la normale au substrat. Avec les orientations précédemment données, les lignes doivent être orientées à un angle de 35 ° par rapport à la direction d'implantation comme le montre la figure 7.

Plus précisément, la figure 7a illustre une vue d'une maille cubique avec ces trois directions. Trois directions d'implantation ionique favorables et répondant au critère du produit scalaire de <111> par <110> sont identifiées Di₁, Di₂ et Di₃.

La figure 7b illustre une représentation schématique d'une ligne d'interconnexion de cuivre L_{cu} avec les trois directions cristallines identifiées, la direction <110> au coeur de la ligne, la direction perpendiculaire <111> et la direction <211> perpendiculaires aux deux précédentes, sur laquelle est également représentée la direction Di₁.

Ces directions Di₁, Di₂ et Di₃ font un angle de 35° avec la perpendiculaire au plan des lignes et correspondent aux directions optimisées d'implantation ionique.

Dans la pratique, l'implantation ionique est effectuée alors qu'une couche de cuivre est située au dessus de la ligne. Cette couche est issue du dépôt électrochimique du cuivre du procédé Damascène décrit précédemment.

L'épaisseur initiale de cette couche est au moins égale à la profondeur des tranchées.

Nous allons décrire ci-après les différentes étapes d'un exemple de procédé selon l'invention permettant de réaliser des lignes d'interconnexion de resistivité optimisée.

### Etape 1 : Détermination de la direction privilégiée D1 des grains dans les tranchées :

On détermine l'orientation des grains qui est favorisée dans les lignes seules. Pour cela, on pratique un retrait de la surépaisseur tout de suite après le dépôt sans aucun recuit. La structure obtenue est semblable à celle illustrée en figure 1e.

Un recuit est alors pratiqué. La température de recuit est comprise entre la température de fusion divisée par quatre et la température de fusion du métal. Pour déterminer l'orientation favorisée à une certaine température de recuit, il faut obtenir une microstructure la plus stable possible. La durée de recuit est longue, au moins une heure.

Après ce traitement, on détermine l'orientation des grains dans les lignes. Cette analyse peut être pratiquée par diffraction des rayons X.

On détermine alors l'angle selon lequel il convient de désorienter le substrat (par rapport à une direction standard d'implantation), sur lequel reposent les lignes de cuivre de façon à placer la direction d'implantation en concordance avec une direction cristallographique <110> favorisée, selon la méthode décrite précédemment.

### Etape 2 : Détermination du choix de l'espèce, de l'énergie et de la dose à implanter :

On choisit l'espèce à implanter. Ce choix est libre parmi les atomes de numéro atomique supérieur à celui du matériau constitutif de la ligne.

On procède à l'opération d'implantation dans la couche au dessus des lignes destinée à être retirée dans un second temps.

L'énergie de l'implantation est choisie de façon à éviter que les ions incidents n'aillent au-delà de la couche supérieure de cuivre. Typiquement, la tension d'accélération est inférieure ou égale à 300 kV.

Une fois que l'espèce, l'énergie et la désorientation sont connues, le procédé est simulé avec le programme « SRIM ». La dose est alors calculée de façon à ce que la densité de défauts présents soit de l'ordre de 100*10²³ lacunes/cm³ créées au total dans le matériau cible.

Un exemple de donnée d'implantation ionique est donné ci-après : l'orientation de films de cuivre de 100 nm d'épaisseur est modifiée par l'implantation ionique d'ions Gallium Ga⁺ à 30keV à une dose de 28*10¹⁵ at/cm².

Dans ces conditions, après le dépôt électrochimique de cuivre, un premier polissage mécano-chimique permet de réduire l'importance de la couche d'invasion de surépaisseur jusqu'à ce qu'elle atteigne environ 150 nm.

### Etape 3 : Réalisation technologique :

Une fois que le procédé d'implantation est choisi, on pratique une simulation avec le programme « SRIM » de façon à connaître la profondeur jusqu'à laquelle le plus d'ions vont aller par ce procédé. Cette profondeur permet de déterminer l'épaisseur de la couche supérieure de cuivre dans laquelle on pratique l'implantation. L'épaisseur de la couche est déterminée de façon à avoir la profondeur à laquelle on obtient le pic de concentration de l'espèce implantée plus 150 nm (+/- 100 nm).

Après le dépôt de cuivre par électrochimie, on pratique un polissage mécano-chimique qui permet de réduire l'épaisseur de la couche supérieure de cuivre jusqu'à ce qu'elle atteigne l'épaisseur déterminée.

L'implantation est alors pratiquée dans les conditions déterminées précédemment.

Un recuit est pratiqué. La température de recuit est la même que celle à laquelle on a déterminé l'orientation la plus favorable des grains de cuivre.

Une fois le recuit pratiqué, on retire le cuivre en excès par polissage mécano-chimique.

## Revendications

1. Procédé de réalisation de lignes d'interconnexion métallique à la surface d'un substrat comportant :
- une étape de gravure pour définir des tranchées au sein dudit substrat ;
- une étape de remplissage desdites tranchées par électrodéposition de cuivre, comprenant en outre la réalisation d'une couche dite d'invasion de métal, au dessus desdites tranchées remplies par des grains de cuivre de manière à définir lesdites lignes d'interconnexion,
**caractérisé en ce qu'**il comporte en outre les étapes suivantes :
- la détermination d'une première direction (D₁) d'orientation de grains le long d'une tranchée, ladite première direction étant définie par l'ensemble cristallographique <110>, ladite première direction étant également la direction privilégiée de canalisations d'ions ;
- d'une seconde direction (D₂) d'orientation de grains dans une direction perpendiculaire à une tranchée, ladite seconde direction étant définie par l'ensemble cristallographique <111 >;
- l'implantation ionique de la couche dite d'invasion par un faisceau d'ions faisant un angle de l'ordre de 35° avec la direction <111 >.

2. Procédé de réalisation de lignes d'interconnexion métallique selon la revendication 1, **caractérisé en ce que** l'épaisseur de la couche d'invasion présente une épaisseur initiale au moins égale à la hauteur d'une tranchée.

3. Procédé de réalisation de lignes d'interconnexion métallique selon l'une des revendications 1 ou 2, **caractérisé en ce que** la détermination de la première direction d'orientation et de la seconde direction des grains dans une tranchée comporte en outre :
- après le dépôt électrochimique, le retrait d'une couche de surépaisseur de manière à dégager le dépôt de cuivre à l'intérieur d'une tranchée;
- une opération de recuit à une température permettant de stabiliser la microstructure obtenue à partir du dépôt de métal à l'intérieur d'une tranchée;
- une analyse par diffraction X permettant d'identifier la première direction d'orientation des grains dans la tranchée.

4. Procédé de réalisation de lignes d'interconnexion métallique selon l'une des revendications 1 à 3, **caractérisé en ce que** l'implantation ionique est effectuée avec des ions de type Ga⁺.

5. Procédé de réalisation de lignes d'interconnexion métallique selon l'une des revendications 1 à 4, **caractérisé en ce que** l'implantation ionique est effectuée par un faisceau de puissance ionique généré avec une tension d'accélération inférieure ou égale à environ 300 kV.

6. Procédé de réalisation de lignes d'interconnexion métallique selon l'une des revendications 1 à 5, **caractérisé en ce qu'**il comporte une étape de recuit postérieure à l'étape d'implantation ionique.

7. Procédé de réalisation de lignes d'interconnexion métallique selon l'une des revendications 1 à 6, **caractérisé en ce qu'**il comporte en outre une étape d'un premier polissage permettant d'optimiser l'épaisseur de la couche dite d'invasion par réduction d'épaisseur, préalable à l'opération d'implantation ionique, en fonction de la largeur de ligne.

8. Procédé de réalisation de lignes d'interconnexion métallique selon l'une des revendications 1 à 7, **caractérisé en ce qu'**il comporte en outre la réalisation d'un dépôt de couche métallique à la surface desdites tranchées de manière à éviter toute diffusion de métal au sein desdites tranchées.

9. Procédé de réalisation de lignes d'interconnexion métallique selon la revendication 7, **caractérisé en ce que** la couche métallique est en métal de type tantale ou nitrure de tantale.

## Patentansprüche

1. Verfahren für die Herstellung von Leitungen mit Metallverbindungen auf der Oberfläche eines Substrats, aufweisend:
- einen Gravurschritt, um innerhalb des Substrats Vertiefungen zu definieren,
- einen Schritt des Füllens der Vertiefungen durch Aufmetallisieren von Kupfer, umfassend ferner die Herstellung einer so genannten Metallinvasionsschicht über den mit Kupferkörnern gefüllten Vertiefungen, um die Verbindungsleitungen zu definieren,
**dadurch gekennzeichnet, dass** es ferner die folgenden Schritte aufweist:
- Bestimmen einer ersten Kornausrichtungsrichtung (D₁) entlang einer Vertiefung, wobei die erste Richtung durch die kristallografische Gruppe <110> bestimmt ist, wobei die erste Richtung ebenfalls die bevorzugte Ionenkanalisationsuchtung ist,
- einer zweiten Kornausrichtungsrichtung (D₂) in einer senkrechten Richtung zu einer Vertiefung, wobei die zweite Richtung durch die kristallografische Gruppe <111> bestimmt ist,
- Ionenimplantation der so genannten Invasionsschicht durch einen Ionenstrahl in einem Winkel von zirka 35° mit der Richtung <111>.

2. Verfahren für die Herstellung von Leitungen mit Metallverbindungen nach Anspruch 1, **dadurch gekennzeichnet, dass** die Dicke der Invasionsschicht eine Ausgangsdicke aufweist, die mindestens gleich der Höhe einer Vertiefung ist.

3. Verfahren für die Herstellung von Leitungen mit Metallverbindungen nach einem der Ansprüche 1 oder 2, **dadurch gekennzeichnet, dass** die Bestimmung der ersten Kornausrichtungsrichtung und der zweiten Kornausrichtungsrichtung in einer Vertiefung ferner umfasst:
- nach dem elektrochemischen Aufbringen das Entfernen einer Überdickenschicht, um das innerhalb einer Vertiefung aufgebrachte Kupfer freizulegen,
- einen Glühvorgang mit einer Temperatur, die erlaubt, die aus dem Metallaufbringen in einer Vertiefung erhaltene Mikrostruktur zu stabilisieren,
- eine Analyse durch Diffraktion X, die erlaubt, die erste Ausuchtungsuchtung der Körner in der Vertiefung festzustellen.

4. Verfahren für die Herstellung von Leitungen mit Metallverbindungen nach einem der Ansprüche 1 bis 3, **dadurch gekennzeichnet, dass** die Ionenimplantation mit Ionen vom Typ Ga⁺ durchgeführt wird.

5. Verfahren für die Herstellung von Leitungen mit Metallverbindungen nach einem der Ansprüche 1 bis 4, **dadurch gekennzeichnet, dass** die Ionenimplantation von einem Strahl mit einer Ionenleistung durchgeführt wird, der mit einer Beschleunigungsspannung von unter oder gleich zirka 300 kV erzeugt wird.

6. Verfahren für die Herstellung von Leitungen mit Metallverbindungen nach einem der Ansprüche 1 bis 5, **dadurch gekennzeichnet, dass** es einen Glühschritt nach dem Ionenimplantationsschritt aufweist.

7. Verfahren für die Herstellung von Leitungen mit Metallverbindungen nach einem der Ansprüche 1 bis 6, **dadurch gekennzeichnet, dass** es ferner einen Schritt einer ersten Politur, die erlaubt, die Dicke der so genannten Invasionsschicht durch Dickenreduzierung zu optimieren, vor dem Vorgang der Ionenimplantation, in Abhängigkeit von der Leitungsbreite, aufweist.

8. Verfahren für die Herstellung von Leitungen mit Metallverbindungen nach einem der Ansprüche 1 bis 7, **dadurch gekennzeichnet, dass** es ferner die Durchführung einer Metallschichtablagerung auf der Oberfläche der Vertiefungen aufweist, um jedwede Metalldiffusion innerhalb der Vertiefungen zu vermeiden.

9. Verfahren für die Herstellung von Leitungen mit Metallverbindungen nach Anspruch 7, **dadurch gekennzeichnet, dass** die Metallschicht aus Metall vom Typ Tantal oder Tantalnitrid ist.

## Claims

1. A method for producing metallic interconnect lines on the surface of a substrate comprising:
- a step of etching for defining trenches within said substrate;
- a step of filling said trenches by copper electrodeposition, further comprising the production of a layer, called metal invasion layer, above said trenches filled with copper grains so as to define said interconnect lines,
**characterised in that** it further comprises the following steps:
- determining a first direction (D₁) of orientation of grains along a trench, said first direction being defined by the crystallographic set <110>, said first direction also being the preferred direction of ion channels;
- determining a second direction (D₂) of orientation of grains in a direction perpendicular to a trench, said second direction being defined by the crystallographic set <111>;
- ion implanting said invasion layer using an ion beam forming an angle of approximately 35° with the direction <111>.

2. The method for producing metallic interconnect lines according to claim 1, **characterised in that** the initial thickness of the thickness of said invasion layer is at least equal to the height of a trench.

3. The method for producing metallic interconnect lines according to one of claims 1 or 2, **characterised in that** determining said first direction of orientation and said second direction of the grains in a trench further comprises:
- removing, after the electrochemical deposition, an excess thickness layer so as to release the copper deposit inside a trench;
- a curing operation at a temperature that allows the microstructure obtained from depositing metal inside a trench to be stabilised;
- an X-ray diffraction analysis that allows said first direction of orientation of the grains in said trench to be identified.

4. The method for producing metallic interconnect lines according to one of claims 1 to 3, **characterised in that** said ion implantation is carried out with ions of the Ga⁺ type.

5. The method for producing metallic interconnect lines according to one of claims 1 to 4, **characterised in that** said ion implantation is carried out by an ion power beam generated with an acceleration voltage that is less than or equal to approximately 300 kV.

6. The method for producing metallic interconnect lines according to one of claims 1 to 5, **characterised in that** it comprises a curing step subsequent to said ion implantation step.

7. The method for producing metallic interconnect lines according to one of claims 1 to 6, **characterised in that** it further comprises a first polishing step that allows the thickness of said invasion layer to be optimised by reducing the thickness, prior to said ion implantation, as a function of the width of the line.

8. The method for producing metallic interconnect lines according to one of claims 1 to 7, **characterised in that** it further comprises depositing a metallic layer on the surface of said trenches so as to prevent any metal diffusion within said trenches.

9. The method for producing metallic interconnect lines according to claim 7, **characterised in that** said metallic layer is a metal of the tantalum or tantalum nitride type.
